# EUROPÄISCHE PATENTSCHRIFT

(11) **EP 1 472 549 B1**
(45) Veröffentlichungstag und Bekanntmachung des Hinweises auf die Patenterteilung: **17.08.2005**
(21) Anmeldenummer: 03737284.4
(22) Anmeldetag: 28.01.2003
(51) Int. Cl.: G01R 21/12

(54) **LEISTUNGSDETEKTOR MIT GLEICHSPANNUNGSENTKOPPLUNG**
POWER DETECTOR WITH CONSTANT VOLTAGE DECOUPLING
DETECTEUR DE PUISSANCE AVEC DECOUPLAGE DE TENSION CONTINUE

(30) Priorität: 08.02.2002 EP 10205359
(43) Veröffentlichungstag der Anmeldung: 03.11.2004
(73) Patentinhaber: Rohde & Schwarz GmbH & Co. KG, 81671 München (DE)
(72) Erfinder: HECHTFISCHER, Gerd, 80805 München (DE); KATZER, Michael, 80337 München (DE)
(74) Vertreter: Körfer, Thomas, Dipl.-Phys.
(86) Internationale Anmeldenummer: PCT/EP2003/000857
(87) Internationale Veröffentlichungsnummer: WO 2003/067270

(56) Entgegenhaltungen:
- WO-A-01/65267
- WO-A-02/14880
- DE-B- 1 103 459

## Beschreibung

Die Erfindung betrifft einen Leistungsdetektor zum Messen der mittleren Leistung modulierter oder unmodulierter Hochfrequenz- bzw. Mikrowellen-Signale.

Leistungsdetektoren sind in den verschiedenartigsten Ausführungsformen bekannt. Die gebräuchlichsten Realisierungen enthalten entweder einen thermischen Sensor, der eine zur absorbierten elektrischen Leistung proportionale elektrische Meßgröße erzeugt, oder sie enthalten einen Diodengleichrichter in Ein- oder Zweiwegschaltung, der eine der Spannung am Abschlußwiderstand äquivalente elektrische Ausgangangsgröße liefert, aus der dann die zu messende Leistung bestimmt werden kann.

Insbesondere die Anforderungen der Kommunikationsstandards für die 2. und 3. Generation im digitalen Mobilfunk führten zur Entwicklung einer neuen Gruppe von Leistungsdetektoren mit einem wesentlich größeren Dynamikbereich für modulierte Signale.

Ein solcher Leistungsdetektor ist beispielsweise aus der nicht vorveröffentlichten DE 100 39 665 der Anmelderin bekannt. Bei dem in dieser Anmeldung beschriebenen Leistungsdetektor ist eine Streifenleitung ohne galvanische Trennung unmittelbar mit dem Eingangsanschluß verbunden. Die Streifenleitung ist durch einen Leistungsteiler abgeschlossen. Am eingangsseitigen und ausgangsseitigen Ende der Streifenleitung befindet sich jeweils eine Detektordiode, die jeweils die positive bzw. negative Halbwelle des Meßsignals detektiert. Die Detektordioden sind zur Erfassung des Meßsignals mit einem Differenzverstärker verbindbar. Wie in der Anmeldung beschrieben, hat die räumliche Trennung der Detektordioden den Vorteil, daß die Anordnung unempfindlicher gegenüber Reflexionen ist. Die Differenz zwischen den Ausgangsspannungen an den beiden Detektordioden ist somit unabhängiger von der Anpassung des Leistungsteilers und den parasitären Diodenkapazitäten. An den Leistungsteiler schließen sich weitere Meßzweige mit vorgeschalteten Dämpfungsstufen an, so daß insgesamt ein relativ großer Dynamikbereich entsteht.

Wenn das Meßsignal mit einem Gleichspannungsanteil behaftet ist, tritt aufgrund des Bahnwiderstands der die Detektordioden verbindenden Streifenleitung und des damit verbundenen Spannungsabfalls jedoch ein Meßfehler auf, der nicht unerheblich ist.

Bisher war es üblich, die Gleichspannungskomponente des Meßsignals durch einen zwischen dem Hochfrequenzanschluß und den Detektordioden angeordneten Trennkondensator zu unterdrücken. Ein solcher Trennkondensator wird beispielsweise bei der US 4,943,764 verwendet. Bei der in dieser Druckschrift vorgeschlagenen Lösung werden darüber hinaus mehrere durch Leistungsteiler voneinander getrennte Diodenpaare zur Vergrößerung des Dynamikbereichs verwendet. Die Detektordioden greifen die beiden Halbwellen jedoch am gleichen Meßpunkt ab, so daß die relative Unempfindlichkeit gegenüber Reflexionen, wie sie sich durch die in der DE 100 39 665 vorgeschlagene räumliche Trennung der Detektordioden ergibt, dort nicht vorhanden ist.

Die Verwendung eines Trennkondensators zur Unterdrückung der Gleichspannungskomponente des Meßsignals hat mehrere Nachteile. Zum einen muß die Kapazität des Trennkondensators relativ groß dimensioniert werden, um eine niedrige untere Grenzfrequenz für eine breitbandige Auslegung des Leistungsdetektors zu erreichen. Dies führt zu einer mechanisch relativ großen Bauform. Zum anderen muß der Trennkondensator für Mikrowellenanwendungen in eine reflexionsarme Hochfrequenzleitung integriert werden. Dies führt zu zusätzlichen störenden Reflexionen und damit zu größeren Meßfehlern.

Aus der DE 1 103 459 B ist eine koaxiale Durchgangsleistungsmeßeinrichtung für das VHF-UHF-Gebiet bekannt, die zur Gleichrichtung einer Hochfrequenzspannung Halbleiterdioden benutzt. Zwei Dioden sind hochfrequenzmäßig parallel und bezüglich ihrer Richtspannungen in Reihe geschaltet, und über einen kapazitiven Rohrteiler an den Innenleiter der koaxialen Leitung angekoppelt.

Aus der WO 02/14880 A (entspricht der ebenfalls nicht vorveröffentlichten Anmeldung DE 100 39 665 A) ist ein Leistungssensor zum Messen der mittleren Leistung modulierter oder unmodulierter Hochfrequenz- oder Mikrowellen-Signale über einen großen Dynamikbereich bekannt. Die zu messende Signalleistung wird einem ersten Sensorzweig zum Messen der Signalleistung in einem niederen Leistungs-Meßbereich zugeführt, der mehrere räumlich voneinander getrennte Meßstellen auf einer Verbindungsleitung zwischen einem Eingang und einem nachfolgenden Leistungsteiler aufweist. Gleichzeitig wird die zu messende Signalleistung über diesen Leistungsteiler mindestens zwei weiteren Sensorzweigen über Dämpfungsglieder zum Messen der Signalleistung in mindestens zwei weiteren unterschiedlichen Leistungs-Meßbereichen zugeführt.

Der Erfindung liegt daher die Aufgabe zugrunde, einen Leistungsdetektor zu schaffen, der relativ unempfindlich gegenüber einer Gleichspannungskomponente und gleichzeitig unempfindlich gegenüber Reflexionen beispielsweise an einem Abschlußwiderstand oder einem Leistungsteiler ist.

Die Aufgabe wird durch die Merkmale des Anspruchs 1 gelöst. Die Unteransprüche enthalten vorteilhafte Weiterbildungen der Erfindung.

Der Erfindung liegt die Erkenntnis zugrunde, daß eine Gleichspannungsentkopplung dadurch erreicht werden kann, daß sich die Abgriffe für die Detektorelemente, beispielsweise die Detektordioden, nicht unmittelbar auf der Signalleitung sondern auf einer Detektionsleitung befinden, die mit der Signalleitung kapazitiv und/oder induktiv gekoppelt ist. Die Detektionsleitung könnte theoretisch von der Signalleitung vollständig galvanisch getrennt sein. Es ist jedoch erfindungsgemäß die Detektionsleitung an nur einer Kontaktposition galvanisch mit der Signalleitung zu verbinden und somit auf ein definiertes Bezugspotential zu legen. Auf keinen Fall sind in Längsrichtung der Signalleitung betrachtet mehr als eine Kontaktposition vorzusehen, so daß in der Detektionsleitung kein Gleichstrom fließt und ein gegebenenfalls vorhandener Spannungsabfall an dem Bahnwiderstand der Signalleitung nicht zu einem Spannungsabfall an der Detektionsleitung führt. Die Spannungsabgriffe an den Detektionspositionen der Detektionsleitung liegen somit auf gleichem Gleichspannungspotential und eine Gleichspannungskomponente des Meßsignals führt nicht zu einem Meßfehler.

Die Kontaktposition zwischen der Signalleitung und der Detektionsleitung kann sich an beliebiger Stelle befinden, beispielsweise in einem der beiden Endbereiche der Leitungen.

Die Detektionsleitung kann auf der Signalleitung in Dünnschicht-Multilayertechnik unter Zwischenlage einer dünnen Isolationsschicht aufgesetzt sein. Grundsätzlich ist es auch denkbar, die Signalleitung und die Detektionsleitung als gekoppelte Leitungen planar nebeneinander auszubilden.

Es ist vorteilhaft, wenn die Leitungsimpedanz der Detektionsleitung relativ gering ist und sich in der gleichen Größenordnung wie der Bahnwiderstand der Signalleitung befindet. Auch wenn die nicht abgeschlossene Detektionsleitung für einzelne Meßfrequenzen resonant ist, ergeben sich aufgrund der niedrigen Kreisgüte durch die hohe Dämpfung keine störend ausgeprägten Resonanzen.

Die erfindungsgemäße Weiterbildung eignet sich sowohl für Zweiweg-Gleichrichter mit jeweils einer Detektordiode für beide Halbwellen als auch für Einweg-Gleichrichter mit nur einer Detektordiode, wobei dann an einer gegenüber der Abgriffsposition der Detektordiode an der Detektionsleitung versetzten Abgriffsposition das Bezugspotential für den Differenzverstärker abgegriffen werden kann.

Mehrere Ausführungsbeispiele der Erfindung werden nachfolgend unter Bezugnahme auf die Zeichnung näher beschrieben. In der Zeichnung zeigen:
- Fig. 1: eine schematische Darstellung einer in der nicht vorveröffentlichten Anmeldung DE 100 39 665 vorgeschlagenen Lösung zur Anordnung der Detektordioden;
- Fig. 2: eine schematische Darstellung eines ersten Ausführungsbeispiels der Erfindung;
- Fig. 3: eine schematische Darstellung eines zweiten Ausführungsbeispiels der Erfindung;
- Fig. 4: Eine mögliche Realisierung des in Fig. 2 dargestellten ersten Ausführungsbeispiels der Erfindung in Koplanartechnik;
- Fig. 5: eine schematische Darstellung eines dritten Ausführungsbeispiels der Erfindung;
- Fig. 6: eine schematische Darstellung eines vierten Ausführungsbeispiels der Erfindung und
- Fig. 7: eine schematische Darstellung eines fünften Ausführungsbeispiels der Erfindung mit mehreren Meßzweigen zur Vergrößerung des Dynamikbereichs.

Fig. 1 zeigt eine schematische Darstellung einer in der nicht vorveröffentlichten Anmeldung DE 100 39 665 der Anmelderin vorgeschlagenen Lösung mit versetzter Anordnung der Detektordioden eines Leistungsdetektors 1.

Ein Hochfrequenzeingang 2 ist mit einer Signalleitung 3 verbunden, die einen Bahnwiderstand R_{B} hat und durch einen Abschlußwiderstand 4, welcher den Widerstandswert R₀ hat, abgeschlossen ist. Ferner sind eine erste Detektordiode 5, die mit ihrer Anode mit der Signalleitung 3 verbunden ist und eine zweite Detektordiode 6, die mit ihrer Kathode mit der Signalleitung 3 verbunden ist, vorgesehen. An dem der Signalleitung 3 gegenüberliegenden Anschluß der Detektordioden 5 und 6 sind jeweils ein Ladekondensator 7 bzw. 8 sowie eine Zuleitung 9 bzw. 10 zu einem Differenzverstärker 11 vorgesehen. Die erste Detektordiode 5 liefert eine dem Meßsignal entsprechende Ausgangsspannung positiver Polarität gegenüber Masse, während die zweite Detektordiode 6 eine dem Meßsignal entsprechende Ausgangsspannung negativer Polarität gegenüber Masse liefert. Der Differenzverstärker 11 unterdrückt etwaige, dem Meßsignal und damit beiden Ausgangsspannungen in gleicher Weise überlagerte Gleichspannungsanteile, so daß an seinem Ausgang 12 ein Meßsignal zur Verfügung steht, das der Leistung des Meßsignals proportional ist, sofern die Detektordioden 5 und 6 in ihrem quadratischen Bereich ausgesteuert werden.

Der Widerstandswert R₀ des Abschlußwiderstands 4 ist im allgemeinen an die Leitungsimpedanz Z₀ der Signalleitung 3 angepaßt. Bei der DE 100 39 665 wird dieser Abschlußwiderstand durch einen Leistungsteiler gebildet, der eine Verzweigung in weitere Meßzweige ermöglicht, die hier zur Vereinfachung weggelassen sind.

Ein völlig reflexionsfreier Abschluß der Signalleitung 3 läßt sich in der Praxis nicht erreichen. Auch an den Detektionspositionen 13 und 14 der Detektordioden 5 und 6 können geringfügige Reflexionen auftreten. Die Auswirkungen dieser Reflexionen können durch einen Versatz in Längsrichtung der Detektionspositionen 13 und 14, der in der nicht vorveröffentlichten DE 100 39 665 A1 der Anmelderin erstmals vorgeschlagen wird, verringert werden. Es sei angenommen, daß der Abstand zwischen den Detektionspositionen 13 und 14 für die höchste zu messende Frequenz des Meßsignals etwa λ/4 beträgt, wobei λ die Wellenlänge bedeutet. Treten beispielsweise an dem Abschlußwiderstand 4 Reflexionen auf, so ist die Phasendifferenz zwischen der einfallenden und der reflektierten Welle an der Detektionsposition 13 um ca. 180° verschieben gegenüber der Detektionsposition 14. Dies bedingt, daß sich einfallende und reflektierte Welle beispielsweise an der Detektionsposition 13 destruktiv überlagern, während sie sich an der Detektionsposition 14 konstruktiv überlagern. Die positive Meßspannung an der Detektordiode 5 wird dadurch etwas verringert, während die negative Meßspannung an der Detektordiode 6 dadurch betragsmäßig etwas vergrößert wird. Durch Addition der Beträge der beiden Meßspannungen in dem Differenzverstärker 11 werden diese Effekte gegeneinander kompensiert, so daß zumindest für die höchste Meßfrequenz eine geringere Reflexionsempfindlichkeit gegeben ist. Für niedrigere Meßfrequenzen ist die Kompensation nicht mehr vollständig; jedoch nimmt der Reflexionsfaktor mit abnehmender Frequenz ohnehin ab, so daß die Notwendigkeit einer Kompensation hauptsächlich am oberen Ende des Meßfrequenzbandes besteht.

Die versetzte Anordnung der Detektionspositionen 13 und 14 auf der Signalleitung 3 hat jedoch den Nachteil, daß die Detektionspositionen 13 und 14 aufgrund des Spannungsabfalls an dem Bahnwiderstand R_{B} der Signalleitung 3 nicht auf exakt gleichem Potential liegen, wenn das an dem Hochfrequenzeingang 3 anliegende Meßsignal eine Gleichspannungskomponente aufweist. Die Detektordioden 5, 6 haben typischerweise eine Gleichrichtempfindlichkeit s=800µV/µW, d. h. bei einer anliegenden Hochfrequenzleistung von 1µW ergibt sich eine gleichgerichtete Spannung von 800µV, wobei ein linearer Zusammenhang zwischen der zu messenden Hochfrequenzleistung und der detektierten Meßspannung für kleine Hochfrequenzleistungen (quadratischer Kennlinienbereich) unterstellt werden kann. Der Bahnwiderstand R_{B} zwischen den beiden Detektordioden 5, 6 beträgt typischerweise R_{B}=0,5Ω. Der Abschlußwiderstand R₀ ist an die Impedanz der Signlleitung 3 angepaßt und trägt typischerweise R₀=50Ω. Die untere Meßgrenze derartiger Diodendetektoren liegt bei ca. 0,1nW. Liegt nun am Hochfrequenzeingang 2 ein Meßsignal mit einer Gleichspannungskomponente von U_{DC}=1mV an, so ergibt sich aufgrund der Spannungsteilung zwischen dem Abschlußwiderstand R₀ und dem Bahnwiderstand R_{B} eine über die Detektordioden 5, 6 an dem Differenzverstärker 11 anliegende Differenzspannung von 10µV. Dies entspricht einer fehlerhaft detektierten Hochfrequenzleistung von 10nW, d. h. die an dem Bahnwiderstand R_{B} abfallende Gleichspannung wird fälschlicherweise als eine am Eingang anliegende Hochfrequenzleistung von 10nW detektiert, die um den Faktor 100 über der möglichen unteren Meßgrenze von 0,1 nW liegt.

Wie bereits dargelegt, wäre die Einfügung eines Trennkondensators zwischen dem Hochfrequenzeingang 2 und der Signalleitung 3 ebenfalls nachteilig. Dieser müßte relativ groß dimensioniert werden, um eine niedrige untere Grenzfrequenz für eine breitbandige Auslegung des Leistungsdetektors zu erreichen. Zum anderen müßte der Trennkondensator in die Signalleitung integriert werden, was zu zusätzlichen störenden Reflexionen und damit größeren Meßfehlern führen würde.

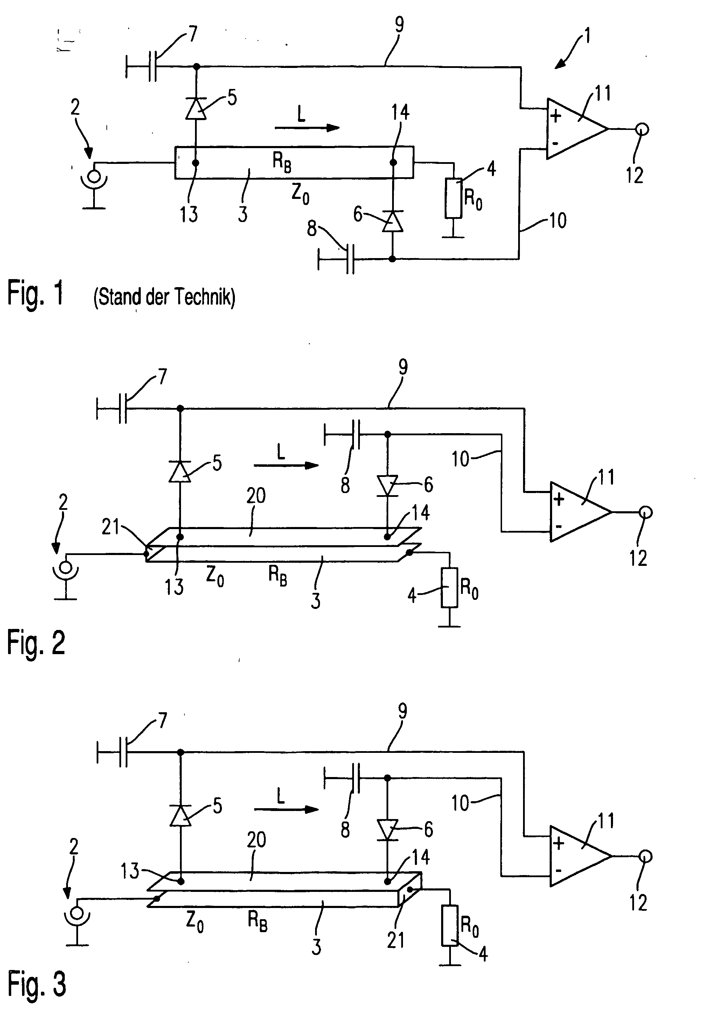

Fig. 2 zeigt ein erstes Ausführungsbeispiel eines erfindungsgemäßen Leistungsdetektors 1 in einer schematischen Darstellung. Gleiche oder sich entsprechende Bauteile sind in allen Zeichnungsfiguren mit übereinstimmenden Bezugszeichen bezeichnet, so daß sich eine wiederholende Beschreibung erübrigt.

Erfindungsgemäß wird vorgeschlagen, die Detektionspositionen für die Detektordioden 5 und 6 bzw. andere Detektorelemente nicht unmittelbar an der Signalleitung 3, sondern an einer Detektionsleitung 20 vorzusehen. Die Detektionsleitung 20 ist im in Fig. 2 dargestellten Ausführungsbeispiel an einer in dem dem Hochfrequenzeingang 2 zugewandten Endbereich angeordneten Kontaktposition 21 mit der Signalleitung 3 verbunden. An allen anderen Stellen ist die Detektionsleitung 20 von der Signalleitung 3 galvanisch getrennt. Wichtig ist, daß in Längsrichtung der Signalleitung 3 betrachtet nur eine Kontaktposition 21 vorhanden ist. Da die Eingangswiderstände des Differenzverstärkers 11 sehr hochohmig sind, fließt in der Detektionsleitung 20 somit kein nennenswerter Strom und die gesamte Detektionsleitung 20 befindet sich auf einem einheitlichen Gleichspannungspotential. Folglich tritt kein Spannungsabfall zwischen den Detektionspositionen 13 und 14 auf. Die Verbindung der Detektionsleitung 20 mit der Signalleitung 3 an in Längsrichtung betrachtet genau einer Kontaktposition ist vorteilhaft, da dadurch die Detektionsleitung 20 auf ein definiertes Bezugspotential gelegt wird. Wichtig ist weiterhin, daß die Detektionsleitung 20 mit der Signalleitung 3 kapazitiv und/oder induktiv so fest gekoppelt ist, daß auf der Detektionsleitung 20 bezüglich der Längenkoordinate L eine ähnliche Spannungsverteilung des Hochfrequenzsignals vorliegt wie auf der Signalleitung 3.

Fig. 3 zeigt ein zweites Ausführungsbeispiel der Erfindung. Im Unterschied zu dem in Fig. 2 dargestellten Ausführungsbeispiel befindet sich die Kontaktposition 21 bei diesem Ausführungsbeispiel nicht an dem dem Hochfrequenzeingang 2 zugewandten eingangsseitigen Ende der Detektionsleitung 20 sondern an dem dem Abschlußwiderstand 4 zugewandten ausgangsseitigen Ende der Detektionsleitung 20. Die Fig. 2 und 3 verdeutlichen nur zwei Beispiele für die Anordnung der Kontaktposition 21. Die Kontaktposition 21 kann sich an beliebiger Stelle in der Längserstreckung der Detektionsleitung 20 befinden.

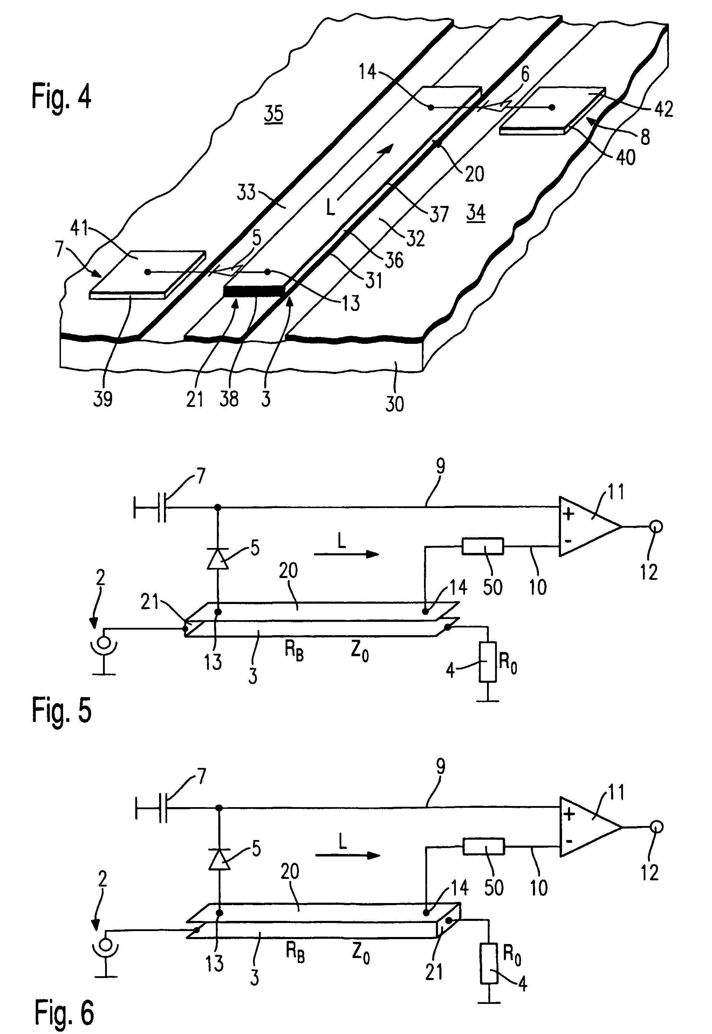

Fig. 4 zeigt eine mögliche Realisierung des in Fig. 2 dargestellten Ausführungsbeispiels in Dünnschicht-Multilayertechnik. Auf einem Substrat 30 aus einem Dielektrikum befindet sich die Signalleitung 3, die im Ausführungsbeispiel als koplanare Streifenleitung ausgeführt ist. Bei der Signalleitung 3 handelt es sich somit um einen dünnen Leitungsstreifen 31, in der Regel aus einem Metall, der jeweils durch einen Abstand 32 bzw. 33 von einer jeweils Massepotential führenden metallischen Massefläche 34 und 35 getrennt ist. Auf dem die Signalleitung 3 bildenden Leitungsstreifen 31 befindet sich eine dünne Isolationsschicht 36 aus einem geeigneten Dielektrikum, beispielsweise Silizium-Nitrid oder SiliziumOxid. Über der Isolationsschicht 36 befindet sich ein weiterer Leitungsstreifen 37, welcher die Detektionsleitung 20 bildet. Die Detektionsleitung 20 ist nur an der Kontaktierungsposition 21, welche durch eine Metallisierung 38 gebildet wird, mit der Signalleitung 3 verbunden. An allen übrigen Positionen entlang der Längsrichtung L ist die Detektionsleitung 20 von der Signalleitung 3 galvanisch getrennt und nur über die dünne, dielektrische Isolationsschicht 36 kapazitiv gekoppelt.

Die Detektionsdioden 5 und 6 sind in Fig. 4 nur schematisch eingezeichnet. Erkennbar sind ferner die Ladekondensatoren 7 und 8, die als Dünnschicht-Kondensatoren ausgebildet sind. Die Bodenelektrode der Dünnschicht-Kondensatoren wird von einem Teil der Masseflächen 35 bzw. 34 gebildet, über welchen sich an der Stelle der Ladekondensatoren 7 bzw. 8 jeweils eine dünne Isolationsschicht 39 bzw. 40, vorzugsweise aus dem gleichen Material wie die Isolationsschicht 36, befindet. Über der Isolationsschicht 39 bzw. 40 befindet sich eine Metallschicht 41 bzw. 42. Da die lokale Ausbildung von Isolationsschichten 39, 40 über der ersten Metallisierung und einer zweiten darüber angeordneten Metallisierung zur Herstellung der Dünnschicht-Kondensatoren 7 bzw. 8 ohnehin erforderlich ist, stellt die Fertigung der durch die Isolationsschicht 36 von der Signalleitung 3 getrennten Detektionsleitung 20 keinen zusätzlichen Aufwand dar und kann durch eine Variation der Herstellungsmasken in gleicher Technologie realisiert werden.

Während in den Fig. 2 bis 4 erfindungsgemäße Ausführungsbeispiele für einen Zweiweg-Gleichrichter dargestellt sind, zeigen die Fig. 5 und 6 zwei Ausführungsbeispiele für einen Einweg-Gleichrichter mit nur einer Detektordiode 5, die an der Detektionsposition 13 angeordnet ist. Die andere Detektionsposition 14 ist jeweils über einen Widerstand 50 mit dem anderen Eingang des Differenzverstärkers 11 verbunden. Die in Fig. 5 und 6 dargestellten Ausführungsbeispiele unterscheiden sich wiederum dadurch, daß sich die Kontaktposition 21 bei dem in Fig. 5 dargestellten Ausführungsbeispiel an dem dem Hochfrequenzeingang 2 zugewandten Ende und bei dem in Fig. 6 dargestellten Ausführungsbeispiel an dem dem Abschlußwiderstand 4 zugewandten Ende der Detektionsleitung 20 befindet. Auch bei einem Einweg-Gleichrichter ist es wichtig, daß sich das über den Widerstand 50 abgegriffene und dem Differenzverstärker 11 zugeführte Bezugspotential auf gleichem Gleichspannungspotential befindet, wie der Abgriff der Detektordiode 5.

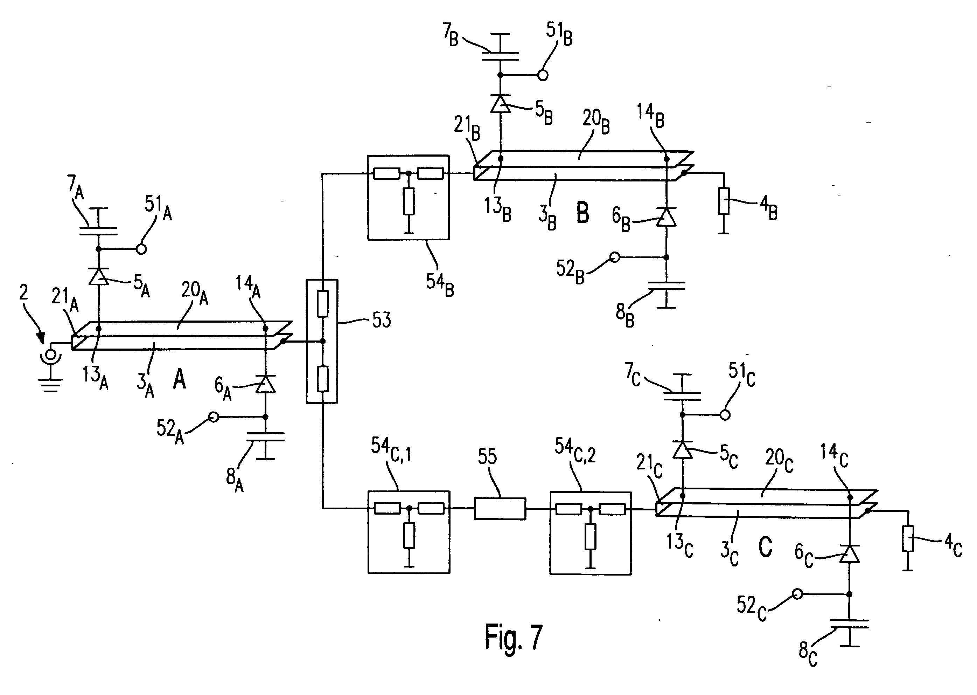

Fig. 7 zeigt ein weiteres Ausführungsbeispiel der Erfindung. Bei dem in Fig. 7 dargestellten Ausführungsbeispiel sind zur Vergrößerung des Dynamikbereichs drei Meßzweige A, B und C vorgesehen, so wie dies in der nicht vorveröffentlichten Anmeldung DE 100 39 665 der Anmelderin grundsätzlich vorgeschlagen wird. Jeder Meßzweig A umfaßt im Ausführungsbeispiel zwei Detektordioden 5_{A}, 6_{A} bzw. 5_{B}, 6_{B} bzw. 5_{C}, 6_{C}, die das Signal, wie anhand von Fig. 2 beschrieben, an Detektionspositionen 13_{A}, 14_{A} bzw. 13_{B}, 14_{B} bzw. 13_{C}, 14_{C} der Detektionsleitung 20_{A} bzw. 20_{B} bzw. 20_{C} abgreifen. Wie anhand von Fig. 2 beschrieben, sind die Detektionsleitungen 20_{A} bzw. 20_{B} bzw. 20_{C} mit den Signalleitungen 3_{A} bzw. 3_{B} bzw. 3_{C} kapazitiv bzw. induktiv gekoppelt und stehen mit dieser nur an einer Kontaktierungsposition 21_{A} bzw. 21_{B} bzw. 21_{C} galvanisch in Verbindung. Die jeweils zwischen den Detektordioden und den Ladekondensatoren 7_{A}, 8_{A} bzw. 7_{B}, 8_{B} bzw. 7_{C}, 8_{C} vorgesehenen Meßpunkte 51_{A}, 52_{A} bzw. 51_{B}, 52_{B} bzw. 51_{C}, 52_{C} stehen jeweils mit einem in Fig. 7 nicht dargestellten Differenzverstärker in Verbindung.

Die Signalleitung 3_{A} des ersten Meßzweigs A ist mit dem Hochfrequenzeingang 2 ohne Zwischenschaltung eines Trennkondensators verbunden und steht ausgangsseitig mit einem Leistungsteiler 53 in Verbindung, der die Leistung gleichmäßig auf den zweiten Meßzweig B und den dritten Meßzweig C aufteilt. Zwischen dem Eingang der Signalleitung 3_{B} des zweiten Meßzweigs B und einem der Ausgänge des Leitungsteilers 53 befindet sich ein erstes Dämpfungselement 54_{B}, das die Ausgangsleistung des Leistungsteilers 53 um einen definierten Dämpfungsfaktor abschwächt. Der Ausgang der Signalleitung 3_{B} ist durch einen Abschlußwiderstand 4_{B} abgeschlossen.

Der Eingang der Signalleitung 3_{C} des dritten Meßzweigs C steht im Ausführungsbeispiel über zwei seriell angeordnete Dämpfungselemente 54_{C,1} und 54_{C,2} mit dem anderen Ausgang des Leitungsteilers 53 in Verbindung. Die Dämpfungselemente 54_{C,1} und 54_{C,2} sind vorzugsweise durch eine Leitung 55 etwas räumlich separiert, um ein direktes Übersprechen von dem Eingang des Dämpfungselements 54_{C,1} auf den Ausgang des Dämpfungselements 54_{C,2} zu vermeiden. Die Signalleitung 3_{C} ist durch einen Abschlußwiderstand 4_{C} abgeschlossen.

Das Meßsignal wird den Signalleitungen 3_{A} bzw. 3_{B} bzw. 3_{C} der unterschiedlichen Meßzweige A, B, C somit in unterschiedlicher Abschwächung zugeführt, so daß sich der Meßzweig A zur Messung im niedrigen Leistungsbereich, der Meßzweig B zur Messung im mittleren Leistungsbereich und der Meßzweig C zur Messung im oberen Leistungsbereich eignet.

Die Erfindung ist nicht auf die dargestellten Ausführungsbeispiele beschränkt. Beispielsweise könnten die Signalleitung 3 und die Detektionsleitung 20 als induktiv gekoppelte Mikrostreifenleitungen mit nur einer Metallisierung auf der Oberseite des Substrats 30 nebeneinander ausgebildet werden, wobei das Substrat, wie bei Mikrostreifenleitungen (Microstripline) üblich, auf der Unterseite eine durchgängige Massemetallisierung aufweist.

## Patentansprüche

1. Leistungsdetektor (1) zum Messen der gleichspannungsfreien Leistung modulierter oder unmodulierter Hochfrequenz- oder Mikrowellen-Signale mit
einer mit einem Hochfrequenzeingang (2) in Verbindung stehenden Signalleitung (3; 3_{A}) und
einer mit der Signalleitung (3; 3_{A}) kapazitiv und/oder induktiv fest gekoppelten Detektionsleitung (20; 20_{A}),
wobei das Signal auf der Detektionsleitung (20; 20_{A}) an zumindest zwei in Längsrichtung (L) versetzten Detektionspositionen (13, 14; 13_{A}, 14_{A}) abgegriffen wird,
die Detektionsleitung (20; 20A) in Längsrichtung (L) betrachtet mit der Signalleitung (3) nur an einer Kontaktposition (21; 21_{A}) verbunden ist und ansonsten von der Signalleitung (3; 3_{A}) galvanisch getrennt ist und
die Detektionsleitung (20) mit der Signalleitung (3) kapazitiv und/oder induktiv so festgekoppelt ist, daß auf der Detektionsleitung (20) bezüglich der Längenkoordinate (L) eine ähnliche Spannungsverteilung des Hochfrequenzsignals vorliegt wie auf der Signalleitung (3).

2. Leistungsdetektor nach Anspruch 1,
**dadurch gekennzeichnet,**
**daß** die Signalleitung (3) und die Detektionsleitung (20) als übereinander angeordnete Leitungsstreifen (31, 37) ausgebildet sind und, abgesehen von der Kontaktposition (21), durch eine dünne Isolationsschicht (32) voneinander getrennt sind.

3. Leistungsdetektor nach Anspruch 2,
**dadurch gekennzeichnet,**
**daß** die die Signalleitung (3) und die Detektionsleitung (20) bildenden Leitungsstreifen (31, 37) von Masseflächen (34, 35) beabstandet sind und zusammen mit diesen koplanare Streifenleitungen bilden.

4. Leistungsdetektor nach einem der Ansprüche 1 bis 3,
**dadurch gekennzeichnet,**
**daß** die Detektionsleitung (20) und die Signalleitung (3) derart gekoppelt sind, daß sie eine Zweidrahtleitung (20, 3) mit einer Leitungsimpedanz (Z₀) bilden, die etwa gleich dem Bahnwiderstand (R_{B}) der Signalleitung (3) ist.

5. Leistungsdetektor nach Anspruch 4,
**dadurch gekennzeichnet,**
**daß** die Leitungsimpedanz (Z₀) der Zweidrahtleitung (20, 3) im Bereich des 0,1 bis 10-fachen, bevorzugt des 0,2 bis 5-fachen, besonders bevorzugt des 0,5- bis 3-fachen des Bahnwiderstandes (R_{B}) der Signalleitung liegt.

6. Leistungsdetektor nach Anspruch 4 oder 5,
**dadurch gekennzeichnet,**
**daß** die Leitungsimpedanz (Z₀) der Zweidrahtleitung (20, 3) so klein gewählt ist, daß keine störenden Resonanzen im Frequenzbereich eines dem Hochfrequenzeingang (2) zugeführten Meßsignals auftreten.

7. Leistungsdetektor nach einem der Ansprüche 1 bis 6,
**dadurch gekennzeichnet,**
**daß** die Kontaktposition (21) in der Nähe eines der beiden Enden der Detektionsleitung (20) angeordnet ist.

8. Leistungsdetektor nach einem der Ansprüche 1 bis 7,
**dadurch gekennzeichnet,**
**daß** die Detektionsleitung (20) eine Länge von etwa einem Viertel der Wellenlänge der höchsten Frequenz eines dem Hochfrequenzeingang (2) zugeführten Meßsignals hat.

9. Leistungsdetektor nach einem der Ansprüche 1 bis 8,
**dadurch gekennzeichnet,**
**daß** jeweils eine Detektionsposition (13, 14) in der Nähe der beiden Enden der Detektionsleitung (20) angeordnet ist.

10. Leistungsdetektor nach einem der Ansprüche 1 bis 9,
**dadurch gekennzeichnet,**
**daß** zwei Detektionspositionen (13, 14) über jeweils eine Detektordiode (5, 6) in zueinander entgegengesetzten Polarität mit den Eingängen eines Differenzverstärkers (11) verbunden sind.

11. Leistungsdetektor nach einem der Ansprüche 1 bis 9,
**dadurch gekennzeichnet,**
**daß** eine Detektionsposition (13) über eine Detektordiode (5) und eine andere Detektionsposition (14) über einen Widerstand (50) mit den Eingängen eines Differenzverstärkers (11) verbunden sind.

12. Leistungsdetektor nach einem der Ansprüche 1 bis 11,
**dadurch gekennzeichnet,**
**daß** zwischen dem Hochfrequenzeingang (2) und der Signalleitung (3) kein Trennkondensator vorhanden ist.

13. Leistungsdetektor nach einem der Ansprüche 1 bis 12,
**dadurch gekennzeichnet,**
**daß** die Signalleitung (3) durch einen Abschlußwiderstand (4) abgeschlossen ist, dessen Widerstandswert (R₀) etwa der Leitungsimpedanz der Signalleitung (3) entspricht.

14. Leistungsdetektor nach einem der Ansprüche 1 bis 12,
**dadurch gekennzeichnet,**
**daß** sich an die Signalleitung (3_{A}) ein Leistungsteiler (53) anschließt.

15. Leistungsdetektor nach Anspruch 14,
**dadurch gekennzeichnet,**
**daß** sich an den Leistungsteiler (53) zumindest zwei Meßzweige (B,C) anschließen, mit jeweils
einer Signalleitung (3_{B}; 3_{C}), die über Dämpfungselemente (54_{B}, 54_{C,1}, 54_{C,2}) mit einem der Ausgänge des Leistungsteilers (53) verbunden sind,
einer mit der Signalleitung (3_{B}; 3_{C}) kapazitiv und/oder induktiv gekoppelten Detektionsleitung (20_{B}; 20_{C}), die in Längsrichtung betrachtet mit der zugeordneten Signalleitung 3_{B}; 3_{C}) nur an höchstens einer Kontaktposition (21_{B}; 21_{C}) verbunden ist und ansonsten von der Signalleitung (3_{B}; 3_{C}) galvanisch getrennt ist,
wobei das Signal auf jeder Detektionsleitung (20_{B}; 20_{C}) an zumindest zwei in Längsrichtung versetzten Detektionspositionen (13_{B}, 13_{C}; 14_{B}, 14_{C}) abgegriffen wird.

## Claims

1. Power detector (1) for measuring the direct-voltage-free power of modulated or un-modulated high-frequency or microwave signals with
a signal line (3; 3_{A}) connected to a high-frequency input (2) and
a detection line (20; 20_{A}) coupled to the signal line (3; 3_{A}) in a firm capacitive and/or inductive manner,
wherein the signal on the detection line (20; 20A) is tapped at least at two detection positions (13, 14; 13_{A}, 14_{A}) offset in the longitudinal direction (L),
the detection line (20; 20A) is connected to the signal line (3) only at one contact position (21; 21A), viewed in the longitudinal direction (L), and is otherwise electrically isolated from the signal line (3; 3A) and
the detection line (20) is coupled in a firm capacitive and/or inductive manner to the signal line (3) such that, with reference to the longitudinal coordinate (L), a similar voltage distribution of the high-frequency signal is present on the detection line (20) to that on the signal line (3).

2. Power detector according to claim 1,
**characterised in that**
the signal line (3) and the detection line (20) are designed as striplines (31, 37) arranged one above the other and isolated from one another by a thin insulation layer (32) except at the contact position (21).

3. Power detector according to claim 2,
**characterised in that**
the striplines (31, 37) forming the signal line (3) and the detection line (20) are spaced at a distance from earth surfaces (34, 35) and, together with the latter, form coplanar striplines.

4. Power detector according to any one of claims 1 to 3,
**characterised in that**
the detection line (20) and the signal line (3) are coupled in such a manner that they form a two-wire line (20,3) with a line impedance (Z₀), which is approximately equivalent to the direct-current-(DC)-resistance (R_{B}) of the signal line (3).

5. Power detector according to claim 4,
**characterised in that**
the line impedance (Z₀) of the two-wire line (20,3) is within the range of 0.1 to 10-times, preferably of the 0.2 to 5-times and by particular preference 0.5 to 3-times the direct-current-(DC)-resistance (R_{B}) of the signal line.

6. Power detector according to claim 4 or 5
**characterised in that**
the line impedance (Z₀) of the two-wire line (20,3) is selected to be so small that no disturbing resonances occur within the frequency range of a measured signal supplied to the high-frequency input (2).

7. Power detector according to any one of claims 1 to 6,
**characterised in that**
the contact position (21) is arranged in the proximity of one of the two ends of the detection line (20).

8. Power detector according to any one of claims 1 to 7,
**characterised in that**
the length of the detection line (20) is approximately one quarter of the wavelength of the highest frequency of a measured signal supplied to the high-frequency input (2).

9. Power detector according to any one of claims 1 to 8,
**characterised in that**,
one detection position (13, 14) is arranged in the proximity of each of the two ends of the detection line (20).

10. Power detector according to any one of claims 1 to 9,
**characterised in that**
two detection positions (13, 14) are each connected via a detector diode (5,6) in mutually opposing polarity to the inputs of a difference amplifier (11).

11. Power detector according to any one of claims 1 to 9,
**characterised in that**
one detection position (13) is connected via a detector diode (5) and another detection position (14) is connected via a resistance (50) to the inputs of a difference amplifier (11).

12. Power detector according to any one of claims 1 to 11,
**characterised in that**
no isolating capacitor is present between the high-frequency input (2) and the signal line (3).

13. Power detector according to any one of claims 1 to 12,
**characterised in that**
the signal line (3) terminates with a terminal resistance (4), of which the resistance value (R₀) corresponds approximately to the line impedance of the signal line (3).

14. Power detector according to any one of claims 1 to 12,
**characterised in that**
a power distributor (53) is connected to the signal line (3_{A}).

15. Power detector according to claim 14,
**characterised in that**
at least two measurement branches (B,C) are connected to the power distributor (53), in each case with
one signal line (3_{B}; 3_{C}), which are connected via attenuation elements (54_{B}, 54_{C,1}, 54_{C,2}) to one of the outputs of the power distributor (53),
and one detection line (20_{B}; 20_{C}) coupled to the signal line (3_{B}; 3_{C}) in a capacitive and/or inductive manner, which, viewed in the longitudinal direction, is connected to the associated signal line (3_{B}; 3_{C}) only at a maximum of one contact position (21_{B}; 21_{C}) and is otherwise electrically isolated from the signal line (3_{B}; 3_{C}),
wherein the signal on each detection line (20_{B}; 20_{C}) is tapped at least at two detection positions (13_{B}, 13_{C}; 14_{B}, 14_{C}) offset in the longitudinal direction.

## Revendications

1. Détecteur de puissance (1) pour la mesure de la puissance exempte de tension continue de signaux haute fréquence ou hyperfréquence modulés ou non modulés avec
une ligne de signaux (3; 3_{A}) en liaison avec une entrée haute fréquence (2) et
une ligne de détection (20; 20_{A}), couplée fixement à la ligne de signaux (3; 3_{A}) d'une manière capacitive et/ou inductive,
où le signal sur la ligne de détection (20; 20_{A}) est pris à au moins deux positions de détection (13, 14; 13_{A}, 14_{A}) décalées dans la direction longitudinale (L),
la ligne de détection (20; 20_{A}), vue dans la direction longitudinale (L), est reliée à la ligne de signaux (3) seulement à une position de contact (21; 21_{A}) et est séparée sinon galvaniquement de la ligne de signaux (3; 3_{A}) et
la ligne de détection (20) est couplée fixement à la ligne de signaux (3) d'une manière capacitive et/ou inductive de façon qu'il existe sur la ligne de détection (20) relativement à la coordonnée de longueur (L) une répartition de tension similaire du signal haute fréquence que sur la ligne de signaux (3).

2. Détecteur de puissance selon la revendication 1.
**caractérisé en ce que**
la ligne de signaux (3) et la ligne de détection (20) sont réalisées comme des bandes de puissance (31,37) disposées l'une au-dessus de l'autre et, à part la position de contact (21) sont séparées l'une de l'autre par une couche d'isolation mince (32).

3. Détecteur de puissance selon la revendication 2.
**caractérisé en ce que**
les bandes de puissance (31, 37) formant la ligne de signaux (3) et la ligne de détection (20) sont espacées de faces massiques (34,35) et forment ensemble avec celles-ci des lignes de bandes coplanaires.

4. Détecteur de puissance selon l'une des revendications 1 à 3
**caractérisé en ce que**
la ligne de détection (20) et la ligne de signaux (3) sont couplées de façon à former une ligne bifilaire (20, 3) avec une impédance de puissance (Zₒ) qui est à peu près égale à la résistance de bande (R_{B}) de la ligne de signaux (3).

5. Détecteur de puissance selon la revendication 4.
**caractérisé en ce que**
l'impédance de puissance (Zₒ) de la ligne bifilaire (20, 3) se situe dans la plage de 0.1 à 10 fois, de préférence de 0.2 à 5 fois, selon une préférence particulière de 0.5 à 3 fois de la résistance de bande (R_{B}) de la ligne de signaux.

6. Détecteur de puissance selon la revendication 4 ou 5. **caractérisé en ce que** l'impédance de ligne (Zₒ) de la ligne bifilaire (20, 3) est sélectionnée suffisamment petite pour qu'il n'y ait pas de résonances gênantes dans la zone de fréquences d'un signal de mesure transmis à l'entrée haute fréquence (2).

7. Détecteur de puissance selon l'une des revendications 1 à 6,
**caractérisé en ce que**
la position de contact (21) est disposée à proximité d'une des deux extrémités de la ligne de détection (20).

8. Détecteur de puissance selon l'une des revendications 1 à 7,
**caractérisé en ce que**
la ligne de détection (20) a une longueur représentant environ un quart de la longueur d'onde de la fréquence la plus élevée d'un signal de mesure transmis à l'entrée haute fréquence (2).

9. Détecteur de puissance selon l'une des revendications 1 à 8,
**caractérisé en ce que**
respectivement une position de détection (13,14) est disposée au voisinage des deux extrémités de la ligne de détection (20).

10. Détecteur de puissance selon l'une des revendications 1 à 9, **caractérisé en ce que** deux positions de détection (13,14) sont reliées par respectivement une diode de détecteur (5, 6), selon une polarité opposée l'une à l'autre, aux entrées d'un amplificateur de différence (11).

11. Détecteur de puissance selon l'une des revendications 1 à 9, **caractérisé en ce qu'**une position de détection (13) est reliée par une diode de détection (5) et une autre position de détection (14) par une résistance (50) aux entrées d'un amplificateur de différence (11).

12. Détecteur de puissance selon l'une des revendications 1 à 11, **caractérisé en ce qu'**il n'existe pas entre l'entrée haute fréquence (2) et la ligne de signaux (3) de condensateur de séparation.

13. Détecteur de puissance selon l'une des revendications 1 à 12, **caractérisé en ce que** la ligne de signaux (3) se termine par une résistance terminale (4) dont la valeur de résistance (Rₒ) correspond à peu près à l'impédance de puissance de la ligne de signaux (3).

14. Détecteur de puissance selon l'une des revendications 1 à 12, **caractérisé en ce qu'**un répartiteur de puissance (53) fait suite à la ligne de signaux (3_{A}).

15. Détecteur de puissance selon la revendication 14, **caractérisé en ce que** le répartiteur de puissance (53) est suivi d'au moins deux branches de mesure (B,G), avec à chaque fois une ligne de signaux (3_{B}; 3_{C}), qui sont reliées par des éléments d'amortissement (54_{B}, 54_{C,1}, 54_{C,2}) à l'une des sorties du répartiteur de puissance (53), une ligne de détection (20_{B}; 20_{C}), couplée avec la ligne de signaux (3_{B}; 3_{C}) de manière capacitive et/ou inductive qui, vue en direction longitudinale, est reliée à la ligne de signaux associée (3_{B}; 3_{C}) seulement à une position de contact au maximum (21_{B}; 21_{C}) et qui est séparée sinon galvaniquement de la ligne de signaux (3_{B}; 3_{C}), où le signal sur chaque ligne de détection (20_{B}; 20_{C}) est pris à au moins deux positions de détection (13_{B}; 13_{C}; 14_{B}; 14_{C}) décalées dans la direction longitudinale.
